(19) Europäisches Patentamt / European Patent Office / Office européen des brevets

(11) **EP 4 456 117 A1**

(12) **EUROPEAN PATENT APPLICATION**
published in accordance with Art. 153(4) EPC

(43) Date of publication:
**30.10.2024 Bulletin 2024/44**

(21) Application number: **22910857.6**

(22) Date of filing: **05.12.2022**

(51) International Patent Classification (IPC):
*H01L 21/20* (2006.01)    *H01L 21/205* (2006.01)

(52) Cooperative Patent Classification (CPC):
**H01L 21/20; H01L 21/2015**

(86) International application number:
**PCT/JP2022/044780**

(87) International publication number:
**WO 2023/120143 (29.06.2023 Gazette 2023/26)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **23.12.2021 JP 2021209976**

(71) Applicant: **Shin-Etsu Handotai Co., Ltd.
Tokyo 100-0004 (JP)**

(72) Inventors:
• **KUBONO Ippei
Annaka-shi, Gunma 379-0196 (JP)**
• **HAGIMOTO Kazunori
Annaka-shi, Gunma 379-0196 (JP)**

(74) Representative: **Mooser, Sebastian Thomas
Wuesthoff & Wuesthoff
Patentanwälte und Rechtsanwalt PartG mbB
Schweigerstraße 2
81541 München (DE)**

(54) **NITRIDE SEMICONDUCTOR SUBSTRATE AND METHOD FOR MANUFACTURING SAME**

(57)    The present invention is a nitride semiconductor substrate including a nitride semiconductor thin film formed on a substrate, in which the nitride semiconductor thin film includes a stress-relaxing layer formed on the substrate and a carbon-doped GaN layer formed on the stress-relaxing layer, and the GaN layer includes high carbon concentration layers and a low carbon concentration layer, the low carbon concentration layer being sandwiched between the high carbon concentration layers and having a lower carbon concentration by 75 % or more than the high carbon concentration layers. This provides the nitride semiconductor substrate with improved crystallinity without increasing a thickness of a GaN epitaxial layer and without using other special materials, and a method for producing the substrate.

[FIG. 1]

EP 4 456 117 A1

**Description**

TECHNICAL FIELD

The present invention relates to a nitride semiconductor substrate and a method for producing the same.

BACKGROUND ART

A MOCVD method, one of the methods of producing a semiconductor thin film, is widely used because of superiority in enlargement of diameter and mass productivity and ability to form a homogeneous thin-film crystal. A nitride semiconductor represented by GaN is expected as a semiconductor material for the next generation, exceeding the limitation of Si as the material.

GaN has characteristics of high saturated electron velocity and thus can produce a device capable of highfrequency operation and operable at a higher output due to a large dielectric breakdown electric field. Moreover, weight reduction, miniaturization, and lower electric power consumption can be expected.

In recent years, the demand for an accelerated communication speed represented by 5G and an accompanying higher output has attracted attention toward a GaN HEMT operable at high frequency and high output. Moreover, GaN is also used for applications in power devices.

In GaN devices, crystallinity of GaN layers often has importance. When many crystal defects are included in the GaN layer, leaks may be generated from the defects as an origin, or performance and lifetime of semiconductor devices may be decreased. Consequently, it is important to reduce crystal defects such as dislocations generated in the GaN layers and improve the crystallinity while securing breakdown voltage when GaN is epitaxially grown on a particular substrate.

Note that, for producing the nitride semiconductor substrate, Patent Documents 1 to 3 can be mentioned, for example.

Patent Document 1 discloses a substrate on which a first semiconductor layer (AlGaN), a second semiconductor layer (AlGaN), a third semiconductor layer (a first GaN region containing carbon and a second GaN region without carbon), and a fourth semiconductor layer (AlGaN) are formed.

Patent Document 2 discloses that a first layer (a stress generating layer: a plurality of nitride semiconductor crystal layers having different compositions) and a second layer containing carbon (GaN: an upper layer portion and a lower layer portion) are formed on a silicon substrate, and an average carbon concentration in the lower layer portion of the second layer is lower than that in the upper layer portion.

Patent Document 3 discloses that an initial nucleation layer, a buffer layer, and an active layer, made of group III nitride semiconductors, are formed on an underlying substrate, and the buffer layer is divided into four regions from $V_1$ to $V_4$, and then discloses a size relationship of each carbon concentration thereof.

CITATION LIST

PATENT LITERATURE

Patent Document 1: JP 2020-98939 A
Patent Document 2: JP 2021-150444 A
Patent Document 3: JP 2016-219690 A

SUMMARY OF INVENTION

TECHNICAL PROBLEM

It is known that thickening GaN epitaxial layer thicknesses improves crystallinity, but thicker GaN layers have problems requiring complex buffer layers, lengthening growth time, increasing raw material costs, generating cracks, and making substrates susceptible to plastic deformation.

In addition, techniques are known in which insertion of SiN intermediate layers formed in island shapes stops dislocations, thereby improving crystallinity, but it is necessary to use special raw materials such as monosilane for forming SiN and it takes a longer formation time, thus increasing costs and decreasing throughput.

The present invention has been made in view of the above-described problem. An object of the present invention is to provide a nitride semiconductor substrate with improved crystallinity without increasing a thickness of a GaN epitaxial layer and without using other special raw materials, and a method for producing the substrate.

SOLUTION TO PROBLEM

To achieve the object, the present invention provides a nitride semiconductor substrate, comprising a nitride semiconductor thin film formed on a substrate, wherein

the nitride semiconductor thin film includes a stress-relaxing layer formed on the substrate and a carbon-doped GaN layer formed on the stress-relaxing layer, and
the GaN layer comprises high carbon concentration layers and a low carbon concentration layer, the low carbon concentration layer being sandwiched between the high carbon concentration layers and having a lower carbon concentration by 75 % or more than the high carbon concentration layers.

According to the inventive nitride semiconductor substrate, a dislocation can be reduced at the low carbon concentration layer while securing a breakdown voltage with the high carbon concentration layer in the GaN layer. Consequently, the crystallinity of the GaN layer can be improved. Moreover, the crystallinity can be improved without increasing the thickness of the GaN layer nor using special raw materials as in conventional methods.
In this case, the carbon concentration in the high carbon concentration layers can be $7 \times 10^{17}$ atoms/cm$^3$ or more and $1 \times 10^{21}$ atoms/cm$^3$ or less.
When the carbon concentration is $7 \times 10^{17}$ atoms/cm$^3$ or more, the breakdown voltage can be more reliably secured. Moreover, when the carbon concentration is $1 \times 10^{21}$ atoms/cm$^3$ or lower, the carbon concentration can be changed simply by adjusting a film formation temperature.
In addition, the carbon concentration in the low carbon concentration layer can be $1 \times 10^{15}$ atoms/cm$^3$ or more and $5 \times 10^{17}$ atoms/cm$^3$ or less.
When the carbon concentration is $1 \times 10^{15}$ atoms/cm$^3$ or more, the carbon concentration can be changed simply by adjusting the film formation temperature. When the carbon concentration is $5 \times 10^{17}$ atoms/cm$^3$ or less, the low carbon concentration layer can function more reliably as the layer to bend (or prevent) the dislocation from the stress-relaxing layer.
Moreover, the low carbon concentration layer can have a film thickness of 200 nm or less.
According to such a film thickness, the thickness of the high carbon concentration layer can be relatively thicker, and thus, the breakdown voltage can be secured higher.
Furthermore, the substrate can be a silicon substrate, or a substrate having a silicon thin film on a surface layer.
These substrates are made of relatively inexpensive materials; thus, production costs are suppressed.
In addition, a crystal axis orientation of the silicon substrate and the silicon thin film can be <111>.
Such as these having the crystal axis orientation are ideal for growing GaN.
Moreover, a total film thickness of the nitride semiconductor thin film can be 10 um or less.
Even when the nitride semiconductor thin film is relatively thin, the dislocation can be sufficiently reduced.
Furthermore, a half-value width of a (0002) plane of the GaN layer can be 315 arcsec or less.
With such a GaN layer, the crystallinity is particularly excellent.
In addition, the high carbon concentration layers and the low carbon concentration layer can be alternately formed as the GaN layer, and
the number of the low carbon concentration layer sandwiched between the high carbon concentration layers can be two or more.
Thus, two or more low carbon concentration layers are provided, and then the dislocations can be more reliably reduced.
Moreover, the present invention provides a method for producing a nitride semiconductor substrate, comprising a nitride semiconductor thin film formed on a substrate, wherein

when a stress-relaxing layer on the substrate and a carbon-doped GaN layer on the stress-relaxing layer are formed as the nitride semiconductor thin film,
high carbon concentration layers and a low carbon concentration layer are formed as the GaN layer, the low carbon concentration layer being sandwiched between the high carbon concentration layers and having a lower carbon concentration by 75 % or more than the high carbon concentration layers.

According to such a production method, the nitride semiconductor substrate having the GaN layer with low dislocation and excellent crystallinity can be reliably produced while securing the breakdown voltage. Moreover, production can be made without using special raw materials while suppressing the thickness of the GaN layer.
In this case, the carbon concentration in the high carbon concentration layers can be $7 \times 10^{17}$ atoms/cm$^3$ or

more and $1 \times 10^{21}$ atoms/cm$^3$ or less.

When the carbon concentration is $7 \times 10^{17}$ atoms/cm$^3$ or more, the breakdown voltage can be more reliably secured. In addition, when the concentration is $1 \times 10^{21}$ atoms/cm$^3$ or less, the carbon concentration can be changed simply by adjusting the film formation temperature.

Moreover, the carbon concentration in the low carbon concentration layer can be $1 \times 10^{15}$ atoms/cm$^3$ or more and $5 \times 10^{17}$ atoms/cm$^3$ or less.

When the carbon concentration is $1 \times 10^{15}$ atoms/cm$^3$ or more, the carbon concentration can be changed simply by adjusting the film formation temperature. Moreover, when the carbon concentration is $5 \times 10^{17}$ atoms/cm$^3$ or less, the low carbon concentration layer can function more reliably as the layer to bend (or prevent) the dislocation from the stress-relaxing layer.

Furthermore, the low carbon concentration layer can have a film thickness of 200 nm or less.

According to such a film thickness, the thickness of the high carbon concentration layer can be relatively thicker, and thus, the breakdown voltage can be secured higher.

In addition, the substrate can be a silicon substrate, or a substrate having a silicon thin film on a surface layer.

Using these substrates can suppress production costs because these materials are relatively inexpensive.

Moreover, a crystal axis orientation of the silicon substrate and the silicon thin film can be <111>.

Using those with such a crystal axis orientation is ideal for growing GaN.

Furthermore, a total film thickness of the nitride semiconductor thin film can be 10 um or less.

Even when the nitride semiconductor thin film is relatively thin, the dislocation can be sufficiently reduced.

In addition, a half-value width of a (0002) plane of the GaN layer can be 315 arcsec or less.

Such a GaN layer having particularly excellent crystallinity can be formed.

Moreover, the high carbon concentration layers and the low carbon concentration layer can be alternately formed as the GaN layer, and

the number of the low carbon concentration layer sandwiched between the high carbon concentration layers can be two or more.

Two or more such low carbon concentration layers are formed, and then the dislocations can be more reliably reduced.

Furthermore, the carbon concentrations in the low carbon concentration layer and the high carbon concentration layers can be controlled by adjusting a film formation temperature.

In this way, the low carbon concentration layer and the high carbon concentration layers can be formed relatively easily.

ADVANTAGEOUS EFFECTS OF INVENTION

According to the inventive nitride semiconductor substrate and the method for producing the substrate, the nitride semiconductor substrate, including the GaN layer, with excellent breakdown voltage characteristics and crystallinity, can be obtained without special raw materials nor thickening the GaN layer.

BRIEF DESCRIPTION OF DRAWINGS

FIG. 1 is a view illustrating an example of a schematic cross-sectional view of a nitride semiconductor substrate according to the present invention.

FIG. 2 is a graph showing a result of an evaluation of crystallinity of a C-dope GaN layer in Examples 1 and 2, and Comparative Example 1.

FIG. 3 is an observation image showing a cross-sectional TEM image including a C-dope GaN layer in Example 1.

FIG. 4 is a graph showing a result of a SIMS profile in Example 2.

FIG. 5 is a graph showing a result of a SIMS profile in Comparative Example 1.

DESCRIPTION OF EMBODIMENTS

Hereinafter, embodiments of the present invention will be described with reference to the drawings. However, the present invention is not limited thereto.

As described above, a nitride semiconductor substrate with improved crystallinity of a GaN layer has been desired. The present inventors have earnestly studied and found out that the nitride semiconductor substrate including a nitride semiconductor film (a stress-relaxing layer and a carbon-doped GaN layer thereon) on a substrate in which the carbon-doped GaN layer includes high carbon concentration layers and a low carbon concentration layer (which is sandwiched between the high carbon concentration layers and has a lower carbon concentration by 75 % or more than the high carbon concentration layers) can improve the crystallinity and secure breakdown voltage without thickening a thickness of the GaN layer, and without using special raw materials such as monosilane as in conventional methods. This finding has led to the completion of the present invention.

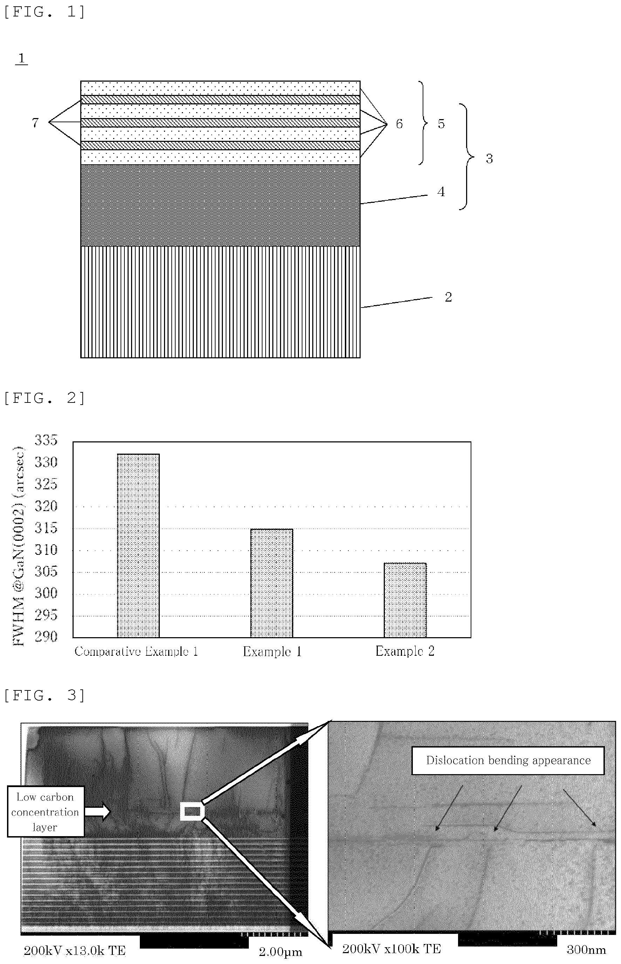

FIG. 1 shows an example of the inventive nitride semiconductor substrate. An inventive nitride semiconductor substrate 1 includes a substrate 2 and a nitride semiconductor thin film 3 formed by epitaxial growth on the substrate 2. This nitride semiconductor thin film 3 is provided with a stress-relaxing layer 4 and a carbon-doped GaN layer (C-dope GaN layer) 5 from the substrate 2 side in sequence.

The substrate 2 is not particularly limited but can be, for example, a silicon substrate. In addition, this substrate may be a substrate having a silicon thin film on a surface layer. Moreover, any substrates, such as a SiC substrate and a bonded substrate, can obtain a similar effect (an improvement of the crystallinity, etc., of the GaN layer 5 described above).

In particular, the silicon substrate or the substrate having the silicon thin film on the surface layer, as described above, can be inexpensive and suppress a production cost, thus preferable. Moreover, in this case, it is preferable that the crystal axis orientation with regard to the silicon substrate or silicon thin film is <111>. This is because such an orientation is ideal for growing GaN thereon.

The stress-relaxing layer 4 can be an epitaxially grown group III nitride semiconductor thin film such as AlN, AlGaN, or GaN. For example, the layer can be an AlN layer formed directly above the substrate 2, an AlGaN layer above that, and a superlattice buffer layer in which two or three layers of AlN, AlGaN, or GaN are each formed with a few nm on top of that. A structure to the superlattice buffer layer is not limited to this, and there is a case where the AlGaN layer is not formed or a case where the AlN layer is further formed on the AlGaN layer. Moreover, a plurality of AlGaN layers with varying Al composition can also be formed. The thickness of this stress-relaxing layer 4 is not limited because the thickness is changed depending on the application.

The carbon-doped GaN layer 5 has high carbon concentration layers 6 (two or more layers) and low carbon concentration layers 7 (one or more layers). Besides, the structure is such that the low carbon concentration layer is sandwiched by the high carbon concentration layers 6 to bend dislocation, which is extended from the substrate 2 sides of the stress-relaxing layer 4 to epitaxial growth direction, thereby improving the crystallinity of the GaN layer 5. In order to obtain this effect sufficiently, the carbon concentration in the low carbon concentration layer 7 is required to be 75 % or more (less than 100 %) lower than that of the high carbon concentration layers 6 in volume concentration [atoms/cm$^3$] (in other words, a relation is as follows. 0% of the carbon concentration in the high carbon concentration layers 6 < the carbon concentration in the low carbon concentration layer 7 $\leq$ 25% of the carbon concentration in the high carbon concentration layers 6).

Here, the low carbon concentration layer 7, sandwiched by the high carbon concentration layers 6, may be not only one layer but also a plurality of layers. That is, the structure can be a plurality of forming of the high carbon concentration layers 6 and the low carbon concentration layers 7 alternately, starting from the stress-relaxing layer 4 in sequence, high carbon concentration layer, low carbon concentration layer, high carbon concentration layer, low carbon concentration layer, high carbon concentration layer and the like. With such a repetition structure, the dislocation described above can be reduced more reliably, resulting in the GaN layer 5 having excellent crystallinity. The more the repetitive structure, the more effectively the above dislocation can be reduced, and therefore the upper limit of the number of low carbon concentration layers cannot be determined. In FIG. 1, the repetitive structure has 4 layers of the high carbon concentration layer 6 and 3 layers of the low carbon concentration layer 7.

In this case, the relation "the low carbon concentration layer 7 has the lower carbon concentration by 75 % or more than the high carbon concentration layers 6" is valid for any combination of layers. For example, even when a layer having the lowest carbon concentration among all high carbon concentration layers 6 is compared with the highest concentration layer among all low carbon concentration layers 7, the relation above is satisfied.

According to such a present invention, using special raw materials such as monosilane on purpose is not required to secure excellent crystallinity as in conventional methods. Moreover, the improvement of the crystallinity is enabled even without thickening the thickness of the GaN layer 5; thus, a harmful effect (increase of formation time and cost, generation of cracks, etc., as described above) due to the thickening of the thickness, can be prevented.

Because the GaN layer 5 is doped with carbon (in particular, owing to the presence of the high carbon concentration layers 6), the breakdown voltage characteristics of the GaN layer 5 can also be made to be sufficient.

Here, the carbon concentration in the high carbon concentration layers 6 and the low carbon concentration layer 7 is only required to satisfy the relation described above and is not limited, but, in particular, can be selected from a concentration range described below.

When the carbon concentration in the high carbon concentration layers 6 is $7\times10^{17}$ atoms/cm$^3$ or more, the breakdown voltage can be more reliably secured. Moreover, in the case of $1\times10^{21}$ atoms/cm$^3$ or less, the carbon concentration can be changed only by adjusting the film formation temperature during epitaxial growth, thus is easy and simple.

In addition, regarding the carbon concentration in the low carbon concentration layer 7, in the case of $1\times10^{15}$ atoms/cm$^3$ or more, the carbon concentration can be changed only by adjusting the film formation temperature during epitaxial growth, thus is easy and simple. Moreover, in the case of $5\times10^{17}$ atoms/cm$^3$ or less, the dislocation from the stress-relaxing layer 4 can be more reliably bent.

Moreover, by holding the film thickness of the low carbon concentration layer 7 (when a plurality of layers is present, the thickness of each layer) to 200 nm or less (but greater than 0 nm), for example, the thickness of the high carbon concentration layers 6 can be relatively thicker, and thus the breakdown voltage of the GaN layer 5 can be further increased.

In addition, a total thickness of the nitride semiconductor thin film 3 (the stress-relaxing layer 4 and the GaN layer 5 are included) is not particularly limited but can be, for example, 10 um or less (but greater than 0 nm). Even in this case, where the film is relatively thin, including the stress-relaxing layer 4, the GaN layer 5 is made to have sufficiently reduced dislocation and improved crystallinity.

In particular, the nitride semiconductor substrate is made to have extremely excellent crystallinity, with a half-value width of a (0002) plane of 315 arcsec or less (but greater than 0 arcsec) in the GaN layer 5.

In addition, on a surface layer side of an epitaxial layer described above, the device layer (not shown) can be provided depending on a necessity. The device layer can be a structure provided with a layer having a high crystallinity where a two-dimensional electron gas is generated (channel layer)(GaN layer), a layer for generating the two-dimensional electron gas (barrier layer), and a Cap layer on the topmost surface layer. AlGaN having Al composition of, for example, about 20% can be used for the barrier layer, but, or, InGaN and the like can also be used, and not limited thereto. The Cap layer can be, for example, a GaN layer or a SiN layer and is not limited thereto. Moreover, a thickness of the device layer or Al composition of the barrier layer can be changed, depending on a device design.

An inventive method for producing a nitride semiconductor substrate is described.

In an MOCVD reactor, first, a stress-relaxing layer 4 made of AlN, AlGaN, and GaN, etc., is epitaxially grown on a substrate 2, such as silicon substrate, as a nitride semiconductor thin film 3.

Subsequently, to begin with, a high carbon concentration layer 6 is epitaxially grown. Then, a low carbon concentration layer 7, having the lower carbon concentration by 75 % or more than the high carbon concentration layer 6, and another high carbon concentration layer 6 are epitaxially grown on the low carbon concentration layer 7 in sequence, thereby obtaining the structure having the low carbon concentration layer 7 sandwiched between the high carbon concentration layers 6. Depending on the necessity, the epitaxial growth of the low carbon concentration layers 7 and the high carbon concentration layers 6 are further repeated a desired number of times. In this way, the structure in which the high carbon concentration layers 6 and the low carbon concentration layers 7 are alternated may be obtained. In this way, the inventive nitride semiconductor substrate 1 can be obtained.

Note that a device layer (channel layer, barrier layer, and Cap layer) may be epitaxially grown on the GaN layer, depending on the necessity later.

When epitaxially grown, for example, TMAl is used as an Al source, TMGa as a Ga source, and $NH_3$ as an N source. Moreover, a carrier gas can be $N_2$ and $H_2$ or either of them, and the film formation temperature can be at about 900 to 1250°C.

In particular, the film formation temperature (substrate surface temperature) of the high carbon concentration layer 6 in the GaN layer can be at about 900 to 1020°C, and the film formation temperature (substrate surface temperature) of the low carbon concentration layer 7 can be about 1030~1150°C in the GaN layer 5 but not limited thereto.

By adjusting the film formation temperature, it is also possible to control carbon concentrations in the high carbon concentration layer 6 and the low carbon concentration layer 7 to the concentrations described above, which is very simple and easy to do. However, a carbon concentration control by externally doping with a raw material, which serves as a C source, is not problematic. Moreover, a step to cool the substrate down once to remove thereof from the MOCVD reactor is not required.

EXAMPLE

Hereinafter, the present invention will be specifically described with reference to Examples and Comparative Examples. However, the present invention is not limited thereto.

(Example 1)

A silicon substrate was mounted in a wafer pocket called a satellite in a MOCVD reactor, and a group III nitride semiconductor thin film was epitaxially grown to produce an inventive nitride semiconductor substrate 1.

Directly above the silicon substrate, being a substrate 2, as a stress-relaxing layer 4, AlN was formed in the first place, then an AlGaN layer was formed thereon, and a superlattice buffer layer which had AlN, AlGaN, and GaN further thereon, each having a few nm thicknesses, was formed (total film thickness of the stress-relaxing layer: 3 pm).

After forming the superlattice buffer layer, a carbon-doped GaN layer 5 (C-dope GaN layer) was formed. In this case, a high carbon concentration layer was formed, then a film formation temperature was raised, and a low carbon concentration layer was formed for about 100 nm. Then, the film formation temperature was lowered, thereby a high carbon concentration layer was formed again (a film thickness of the high carbon concentration layer adjacent to the stress-relaxing layer: 250 nm, a film thickness of the high carbon concentration layer on the low carbon concentration layer: 100 nm).

In this case, the film formation temperature (substrate surface temperature) of the high carbon concentration layer was adjusted so as to be about 960°C, and a carbon concentration was made to be a concentration from about $8 \times 10^{17}$ to $5 \times 10^{18}$ atoms/cm$^3$. Moreover, the film formation temperature (substrate surface temperature) of the low carbon concentration layer was adjusted so as to be about 1040°C, and a carbon concentration was made to be a concentration from about $1 \times 10^{17}$ to $2 \times 10^{17}$ atoms/cm$^3$, and as can be understood from an expression below, the low carbon concentration layer was made to have the lower concentration by 75 % or more than the high carbon concentration layers.

$$(2 \times 10^{17} \ / \ 8 \times 10^{17}) \ \times \ 100 \ = \ 25 \ \%$$

(that is, the lower carbon concentration by 75 %).

A control of the carbon concentration was made only by adjustment of these film formation temperatures, and an external doping of a carbon source, etc., was not used.

A device layer was provided on a surface layer side of an epitaxial layer. The device layer was provided with a layer having a high crystallinity where a two-dimensional electron gas was generated (channel layer), a layer for generating the two-dimensional electron gas (barrier layer), and a Cap layer on the topmost surface layer. The channel layer was the GaN layer of about 0.7 um, the barrier layer was AlGaN of about 22nm, having an Al composition of about 20 %, and the Cap layer was the GaN layer of about 3 nm.

In addition, when these stress-relaxing layer, C-dope GaN layer, and device layer were epitaxially grown, TMAl was used as an Al source, TMGa as a Ga source, and NH3 as an N source. Moreover, $N_2$ and $H_2$ were used as carrier gases, and a process temperature from start to end of forming was about 900 to 1150°C.

The nitride semiconductor thin film (in this case, the stress-relaxing layer, the C-dope GaN layer, and the device layer) had a total film thickness of about 6 um.

Moreover, a half-value width of a (0002) plane of the GaN layer was measured by an XRD measurement, and then the crystallinity of GaN was evaluated after the epitaxial growth. A result of the evaluation is shown in FIG. 2. The narrower half-value width indicates higher crystallinity; thus, Example 1 (315 arcsec) had significantly better crystallinity than Comparative Example 1 (332 arcsec) described later.

In addition, the C-dope GaN layer and the stress-relaxing layer were observed by cross-sectional TEM, and a state in which a dislocation was bent was confirmed. An observation image is shown in FIG. 3. When the low carbon concentration layer was magnified, a state in which the dislocation extending from the substrate side to a growth direction was bent at the low carbon concentration layer was confirmed.

(Example 2)

In Example 1, a high carbon concentration layer was formed adjacent to a stress-relaxing layer, then a low carbon concentration layer and a high carbon concentration layer were formed once each; however, in Example 2, formations were alternately performed three times each, as shown in FIG. 1, to make the total number of the low carbon concentration layers sandwiched by the high carbon concentration layers to three layers, thereby forming a repetition structure made of the high carbon concentration layers and the low carbon concentration layers. Other forming conditions were as in Example 1.

(The film thickness, and the carbon concentration) of the four layers of the high carbon concentration layers were about (250 nm, $8 \times 10^{17}$ atoms/cm$^3$), (250 nm, $1.5 \times 10^{18}$ atoms/cm$^3$), (250 nm, $2 \times 10^{18}$ atoms/cm$^3$), (1000 nm, $4 \times 10^{18}$ atoms/cm$^3$) in the order from a substrate side. Moreover, (the film thickness, and the carbon concentration) of the three layers of the low carbon concentration layers were about (125 nm, $1 \times 10^{17}$ atoms/cm$^3$), (125 nm, $1.5 \times 10^{17}$ atoms/cm$^3$), (125 nm, $2 \times 10^{17}$ atoms/cm$^3$) in the order from the substrate side.

When the carbon concentration was compared between a layer having the lowest carbon concentration ($8 \times 10^{17}$ atoms/cm$^3$) among all high carbon concentration layers and a layer having the highest carbon concentration ($2 \times 10^{17}$ atoms/cm$^3$) among all low carbon concentration layers, the concentration of the low carbon concentration layer was lower by 75 % or more than that of the high carbon concentration layer, as can be understood from an expression below.

$$(2 \times 10^{17} / 8 \times 10^{17}) \times 100 = 25 \%$$

(that is, the lower carbon concentration by 75 %).

In addition, each of the total film thicknesses of the stress-relaxing layer and the film thickness of a device layer were same as in Example 1, and a total film thickness of a nitride semiconductor thin film (in this case, the stress-relaxing layer, a C-dope GaN layer and the device layer) was about 6 um.

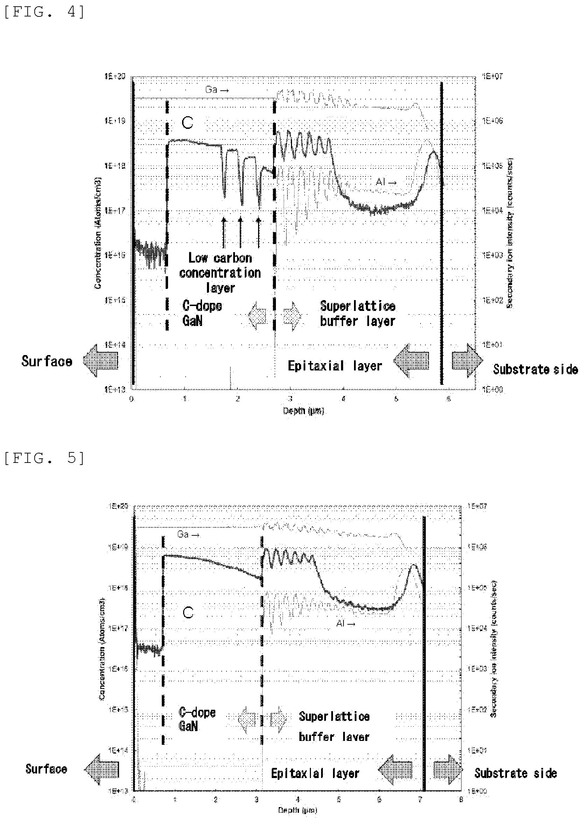

Moreover, a profile (SIMS measurement) of the carbon concentration is shown in FIG. 4.

When a crystallinity evaluation was performed by an XRD measurement after film forming, as in Example 1 (FIG. 2), the result was 307 arcsec, and the crystallinity was significantly better than in Comparative Examples. Moreover, the crystallinity was higher than that of Example 1. It is considered that forming a plurality of the low carbon concentration layers sandwiched by the high carbon concentration layers enabled further reduction of dislocation.

In addition, a SIM measurement confirmed that each low carbon concentration layer was sandwiched by the high carbon concentration layers.

(Comparative Example 1)

A structure made of high carbon concentration layers and a low carbon concentration layer as Examples 1 and 2 was not formed. Instead, a GaN layer having a carbon concentration of $1.5 \times 10^{18}$ atoms/cm$^3$ to $7 \times 10^{18}$ atoms/cm$^3$ was formed as shown in a carbon concentration profile (SIMS measurement) of FIG. 5. Other forming conditions were as in Examples 1 and 2.

When a crystallinity evaluation was performed by an XRD measurement as in Examples 1 and 2, after film forming (FIG. 2), the result was 332 arcsec as described before, and crystallinity was significantly lower than that of Examples 1 and 2.

In addition, it was confirmed that a structure was absent, in which the low carbon concentration layer was sandwiched by the high carbon concentration layers, by a SIM measurement.

(Comparative Example 2)

Regarding a C-dope GaN layer of Example 1, a carbon concentration of a high carbon concentration layer was similar (i.e., about $8 \times 10^{17}$ to $5 \times 10^{18}$ atoms/cm$^3$), and a carbon concentration of a low carbon concentration layer was about $2.4 \times 10^{17}$ atoms/cm$^3$, and as can be understood from an expression below, the low carbon concentration layer had the lower concentration by only 70 % than the high carbon concentration layer.

$$(2.4 \times 10^{17} / 8 \times 10^{17}) \times 100 = 30 \%$$

(that is, the lower carbon concentration by 70%)

The nitride semiconductor substrate was otherwise produced the same way as in Example 1.

When a crystallinity evaluation was performed by an XRD measurement after film forming, as in Examples 1 and 2, the result was 326 arcsec, a value close to Comparative Example 1, and crystallinity was significantly lower than that of Examples 1 and 2.

Hence, a difference of about 70 % in carbon concentration between a high carbon concentration layer and a low carbon concentration layer was insufficient to bend dislocation for improving the crystallinity of a C-dope GaN layer.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

**Claims**

1.  A nitride semiconductor substrate, comprising a nitride semiconductor thin film formed on a substrate, wherein

    the nitride semiconductor thin film includes a stress-relaxing layer formed on the substrate and a carbon-doped GaN layer formed on the stress-relaxing layer, and
    the GaN layer comprises high carbon concentration layers and a low carbon concentration layer, the low carbon concentration layer being sandwiched between the high carbon concentration layers and having a lower carbon concentration by 75 % or more than the high carbon concentration layers.

2. The nitride semiconductor substrate according to claim 1, wherein
the carbon concentration in the high carbon concentration layers is $7\times10^{17}$ atoms/cm$^3$ or more and $1\times10^{21}$ atoms/cm$^3$ or less.

3. The nitride semiconductor substrate according to claim 1 or 2, wherein
the carbon concentration in the low carbon concentration layer is $1\times10^{15}$ atoms/cm$^3$ or more and $5\times10^{17}$ atoms/cm$^3$ or less.

4. The nitride semiconductor substrate according to any one of claims 1 to 3, wherein
the low carbon concentration layer has a film thickness of 200 nm or less.

5. The nitride semiconductor substrate according to any one of claims 1 to 4, wherein
the substrate is a silicon substrate, or a substrate having a silicon thin film on a surface layer.

6. The nitride semiconductor substrate according to any one of claims 1 to 5, wherein
a crystal axis orientation of the silicon substrate and the silicon thin film is <111>.

7. The nitride semiconductor substrate according to any one of claims 1 to 6, wherein
a total film thickness of the nitride semiconductor thin film is 10 um or less.

8. The nitride semiconductor substrate according to any one of claims 1 to 7, wherein
a half-value width of a (0002) plane of the GaN layer is 315 arcsec or less.

9. The nitride semiconductor substrate according to any one of claims 1 to 8, wherein

the high carbon concentration layers and the low carbon concentration layer are alternately formed as the GaN layer, and
the number of the low carbon concentration layer sandwiched between the high carbon concentration layers is two or more.

10. A method for producing a nitride semiconductor substrate, comprising a nitride semiconductor thin film formed on a substrate, wherein

when a stress-relaxing layer on the substrate and a carbon-doped GaN layer on the stress-relaxing layer are formed as the nitride semiconductor thin film,
high carbon concentration layers and a low carbon concentration layer are formed as the GaN layer, the low carbon concentration layer being sandwiched between the high carbon concentration layers and having a lower carbon concentration by 75 % or more than the high carbon concentration layers.

11. The method for producing a nitride semiconductor substrate according to claim 10, wherein
the carbon concentration in the high carbon concentration layers is $7\times10^{17}$ atoms/cm$^3$ or more and $1\times10^{21}$ atoms/cm$^3$ or less.

12. The method for producing a nitride semiconductor substrate according to claim 10 or 11, wherein
the carbon concentration in the low carbon concentration layer is $1\times10^{15}$ atoms/cm$^3$ or more and $5\times10^{17}$ atoms/cm$^3$ or less.

13. The method for producing a nitride semiconductor substrate according to any one of claims 10 to 12, wherein
the low carbon concentration layer has a film thickness of 200 nm or less.

14. The method for producing a nitride semiconductor substrate according to any one of claims 10 to 13, wherein
the substrate is a silicon substrate, or a substrate having a silicon thin film on a surface layer.

15. The method for producing a nitride semiconductor substrate according to any one of claims 10 to 14, wherein
a crystal axis orientation of the silicon substrate and the silicon thin film is <111>.

16. The method for producing a nitride semiconductor substrate according to any one of claims 10 to 15, wherein a total film thickness of the nitride semiconductor thin film is 10 um or less.

17. The method for producing a nitride semiconductor substrate according to any one of claims 10 to 16, wherein a half-value width of a (0002) plane of the GaN layer is 315 arcsec or less.

18. The method for producing a nitride semiconductor substrate according to any one of claims 10 to 17, wherein

the high carbon concentration layers and the low carbon concentration layer are alternately formed as the GaN layer, and
the number of the low carbon concentration layer sandwiched between the high carbon concentration layers is two or more.

19. The method for producing a nitride semiconductor substrate according to any one of claims 10 to 18, wherein the carbon concentrations in the low carbon concentration layer and the high carbon concentration layers are controlled by adjusting a film formation temperature.

# EP 4 456 117 A1

[FIG. 1]

[FIG. 2]

[FIG. 3]

[FIG. 4]

[FIG. 5]

## INTERNATIONAL SEARCH REPORT

| International application No. |
|---|
| **PCT/JP2022/044780** |

**A.     CLASSIFICATION OF SUBJECT MATTER**

*H01L 21/20*(2006.01)i; *H01L 21/205*(2006.01)i
FI:    H01L21/20; H01L21/205

According to International Patent Classification (IPC) or to both national classification and IPC

**B.     FIELDS SEARCHED**

Minimum documentation searched (classification system followed by classification symbols)

H01L21/20; H01L21/205

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C.     DOCUMENTS CONSIDERED TO BE RELEVANT**

| Category* | Citation of document, with indication, where appropriate, of the relevant passages | Relevant to claim No. |
|---|---|---|
| X | JP 2015-207624 A (SANKEN ELECTRIC COMPANY, LIMITED) 19 November 2015 (2015-11-19) paragraphs [0003], [0007], [0009], [0026], [0044]-[0046], fig. 5-8, 10 | 1-5, 8, 10-14, 17, 19 |
| Y | | 6-9, 15-19 |
| Y | JP 2014-022685 A (NAGOYA INSTITUTE OF TECHNOLOGY) 03 February 2014 (2014-02-03) paragraphs [0011], [0018], [0045], [0051], table 1 | 6-9, 15-19 |
| Y | CN 106653839 A (SOUTH CHINA UNIVERSITY OF TECHNOLOGY) 10 May 2017 (2017-05-10) paragraphs [0034], [0041]-[0059], fig. 2-4 | 9, 18, 19 |
| A | JP 2011-082494 A (COVALENT MATERIALS CORPORATION) 21 April 2011 (2011-04-21) entire text, all drawings | 1-19 |

☐ Further documents are listed in the continuation of Box C.        ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **06 February 2023** | **14 February 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
**Information on patent family members**

International application No.

**PCT/JP2022/044780**

| Patent document cited in search report | | | Publication date (day/month/year) | Patent family member(s) | | | Publication date (day/month/year) |
|---|---|---|---|---|---|---|---|
| JP | 2015-207624 | A | 19 November 2015 | US 2017/0033209 A1 paragraphs [0005], [0017], [0019], [0052]-[0055], [0092]-[0101], fig. 5-8, 10 WO 2015/159481 A1 TW 201541635 A CN 106233440 A KR 10-2016-0141756 A | | | |
| JP | 2014-022685 | A | 03 February 2014 | (Family: none) | | | |
| CN | 106653839 | A | 10 May 2017 | (Family: none) | | | |
| JP | 2011-082494 | A | 21 April 2011 | US 2011/0062556 A1 entire text, all drawings DE 102010045196 A1 | | | |

Form PCT/ISA/210 (patent family annex) (January 2015)

**EP 4 456 117 A1**

**REFERENCES CITED IN THE DESCRIPTION**

**Patent documents cited in the description**

- JP 2020098939 A
- JP 2021150444 A
- JP 2016219690 A